# EUROPÄISCHE PATENTSCHRIFT

(11) **EP 0 638 185 B1**
(45) Veröffentlichungstag und Bekanntmachung des Hinweises auf die Patenterteilung: **28.02.1996**
(21) Anmeldenummer: 93907783.0
(22) Anmeldetag: 05.04.1993
(51) Int. Cl.: G06F 11/26

(54) **VERFAHREN ZUM PRÜFEN VON MIT EINER VIELZAHL VON UNTERSCHIEDLICHEN BAUSTEINEN BESTÜCKTEN BAUGRUPPEN**
PROCESS FOR TESTING MODULES FITTED WITH A PLURALITY OF DIFFERENT COMPONENTS
PROCEDE DE CONTROLE DE MODULES EQUIPES D'UNE PLURALITE DE COMPOSANTS DIFFERENTS

(30) Priorität: 28.04.1992 DE 4213905
(43) Veröffentlichungstag der Anmeldung: 15.02.1995
(73) Patentinhaber: Siemens Nixdorf Informationssysteme Aktiengesellschaft, D-33102 Paderborn (DE)
(72) Erfinder: TANNHÄUSER, Rolf, D-8033 Krailling (DE)
(74) Vertreter: Fuchs, Franz-Josef, Dr.-Ing.
(86) Internationale Anmeldenummer: DE9300318
(87) Internationale Veröffentlichungsnummer: WO9322724

(56) Entgegenhaltungen:
- EP-A- 0 090 757
- IEEE TRANSACTIONS ON COMPUTER AIDED DESIGN OF INTEGRATED CIRCUITS AND SYSTEMS Bd. 11, Nr. 1, Januar 1992, New York, US, Seiten 76-82; D.L. LANDIS: 'A test methodology for wafer scale systems'
- PROCEEDINGS OF THE INTERNATIONAL TEST CONFERENCE, 28. Oktober-1. November 1991, Seiten 113-121, IEEE, New York, US; K.E. POSSE: 'A design-for-testability architecture for multichip modules'
- RESEARCH DISCLOSURE Nr. 276, April 1987, New York, US, S. 244; 'Circuit board tester'

## Beschreibung

### Verfahren zum Prüfen von mit einer Vielzahl von unterschiedlichen Bausteinen bestückten Baugruppen

Die Erfindung betrifft ein Verfahren zum Prüfen von mit Boundary-Scanzellen ausgestatteten mit einer Vielzahl von unterschiedlichen Bauelementen bestückten Baugruppen.

Digitale Baugruppen werden bisher mit Funktionstestern und Incircuittestern geprüft. Diese Tester benötigen zur Stimulierung und Beobachtung der Prüflingssignale Pinelektroniken, so z.B. beim Funktionstester eine Pinelektronik pro Signalpin der Baugruppe. Die Pinelektroniken sind technisch sehr aufwendig und bestimmen deshalb auch weitgehend die Hardwarekosten der Testsyteme.

Andererseits sind in den heutigen Bauelementen schon vielfach sogenannte Boundary-Scanzellen integriert, die eine einfache Funktionsprüfung mehrerer Bauelemente gleichzeitig durch Zusammenschalten zu einem Scanpath in einfacher Weise ermöglichen. Beim Boundary-Scanprüfverfahren lassen sich alle Eingangs- und Ausgangssignale der Bausteine auf der Baugruppe zu einem Scanpath zusammenschalten. Dieser Scanpath ist auf vier bzw. fünf Steckerpins der Baugruppe geführt. Somit können alle Bausteineingangs- und -ausgangssignale innerhalb der Baugruppe über diese Steckerpins stimuliert bzw. beobachtet werden. Dies erlaubt den Test der einzelnen Bausteine und deren Verbindungen untereinander. Signalstrecken, die jedoch zum Baugruppenstecker (auf Signalpins) führen, können damit nicht geprüft werden. Für diese Signalpins benötigen konventionelle Funktionstester vielmehr jeweils eine teuere Pinelektronik.

Aus IEEE TRANSACTIONS ON COMPUTER AIDED DESIGN OF INTEGRATED CIRCUITS AND SYSTEMS, Bd. 11, Nr. 1, Januar 1992, NEW YORK US, Seiten 76 - 82, wo ein Artikel "A test methodology for wafer scale systems" von D.L. LANDIS veröffentlicht ist, ist ein eingangs erwähntes entsprechendes Boundary-Scanprüfverfahren bekannt. Dabei können die interne Logik der Bausteine, als auch deren Verbindungen ("external test") geprüft werden. Es können aber nicht die Baugruppeneingangs- und die Baugruppenausgangsleitungen getestet werden.

Aus der EP-A-O 090 757 ist zwar eine Methode bekannt, Baugruppeneingangs- und Baugruppenausgangsleitungen zu testen. Diese Methode steht aber in keiner Verbindung mit einem Boundary-Scanprüfverfahren.

Aufgabe der vorliegenden Erfindung ist es daher, auch für die Prüfung von Signalstrecken zu den Signalpins ein Boundary-Scanprüfungsverfahren anzugeben, das eine Prüfung dieser Signalstrecken ohne großen Aufwand ermöglicht.

Zur Lösung dieser Aufgabe wird gemäß der Erfindung derart verfahren, daß mittels eines Adapters jeweils eine Baugruppenausgangssignalleitung mit einer oder mehreren Baugruppeneingangssignalleitungen verbunden wird und daß mittels des externen Prüfmodus das Boundary-Scanprüfverfahren durchgeführt wird.

Durch diese Maßnahmen lassen sich Funktionstester mit teurer Pinelektronik vermeiden, ohne daß die Qualität der Prüfung wesentlich verringert wird.

Bei der Festlegung der Kurzschlußverbindungen von Signalausgängen zu Signaleingängen der Baugruppe in diesem Adapter ist lediglich darauf zu achten, daß die kurzgeschlossenen Signalverbindungen auf Grund der Signalführung innerhalb der Baugruppe keine Kurzschlüsse durch Fertigungsfehler aufweisen können. Dies erreicht man dadurch, daß man jeweils auf der Baugruppe weit auseinanderliegende Leitungen über den Adapter miteinander verbindet.

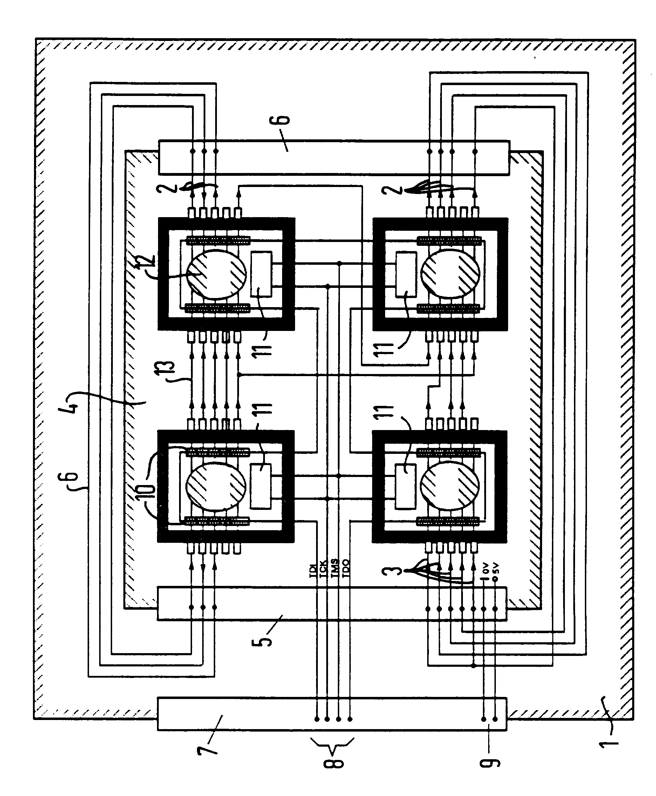

Anhand der Figur wird die Erfindung näher erläutert. Die Figur zeigt den Prüfling 4, der im vorliegenden Fall z.B. aus einer Baugruppe mit vier Bausteinen A, B, C und D besteht, wobei die Bausteine mit Boundary-Scanzellen 10 ausgestattet sind. Diese Boundary-Scanzellen werden zwischen den Pads und der internen Logik der Bausteine eingefügt und können während des Betriebs der Schaltung für Testzwecke benutzt werden. Uber einen Test-Access-Port (TAP) wird das jeweilige Schieberegister des einen Bausteins mit dem jeweils darauffolgenden Baustein verbunden. Damit können ähnlich dem Scanpath bei Bauelementen auf einer Baugruppe seriell Testdaten ein- und ausgeschoben werden. Mit dieser Prüfmethode kann sowohl die Funktionsfähigkeit der internen Logik 12 der Bausteine, als auch die Logik und Verdrahtung 13 zwischen den Bausteinen geprüft werden. Zu diesem Zweck wird an dem Boundary Scan Bus 8 ein Boundary-Scantestgerät angeschlossen, durch das über den Pin TDI (Testdateninput) alle Testdaten und Instruktionen seriell eingeschoben und über den Pin TDD (Testdatenoutput) alle Testantworten seriell ausgeschoben werden. Durch ein serielles Protokoll an einem weiteren Pin TMS werden die Testaktivitäten auf dem Bauelement gesteuert und mit Hilfe eines vom Systemtakt unabhängigen Testtakts am Pin TCK kann auch während des Betriebs auf die Testeinrichtungen zugegriffen werden. Der Test-Access-Port TAP erlaubt die Steuerung und den Zugriff auf testunterstützende Schaltungen innerhalb der Bausteine. Der TAP-Controler 11 empfängt das serielle Protokoll über den Pin TMS und leitet daraus interne Steuersignale ab.

Nicht geprüft mit dieser Boundary-Scanmethode können jedoch die Baugruppeneingangssignalleitungen 3 und die Baugruppenausgangssignalleitungen 2 des Prüflings 4 werden.

Verbindet man aber mittels eines Prüfadapters 1, der die Prüflingsstecker 5, 6 sowie einen Adaptereingangsstecker 7 enthält, jeweils eine Baugruppenausgangssignalleitung 2 mit einer oder mehreren Baugruppeneinangssignalleitungen 3, so läßt sich das Boundary-Scanprüfverfahren unter Verwendung des externen Prüfmodus auch zur Prüfung der Eingangs- und Ausgangssignalleitungen der jeweiligen Baugruppe mit Erfolg verwenden. Die Prüflingsstromversorgung wird dabei über die Eingangsklemmen 9 zugeführt.

## Patentansprüche

1. Verfahren zum Prüfen von mit Boundary-Scanzellen ausgestatteten mit einer Vielzahl von unterschiedlichen Bausteinen bestückten Baugruppen, **dadurch gekennzeichnet**, daß mittels eines Adapters (1) jeweils eine Baugruppenausgangssignalleitung (2) mit einer oder mehreren Baugruppeneingangssignalleitungen (3) verbunden wird und daß dann der externe Prüfmodus des Boundary-Scanprüfverfahrens durchgeführt wird.

## Claims

1. Process for testing modules equipped with boundary scanning cells and fitted with a multiplicity of different components, characterized in that in each case one module output signal line (2) is connected by means of an adapter (1) to one or more module input signal lines (3), and in that the external test mode of the boundary scan testing process is then performed.

## Revendications

1. Procédé de contrôle de modules équipés de cellules Boundary-Scan, ayant une multiplicité de composants différents, caractérisé par le fait qu'au moyen d'un adaptateur (1), on relie respectivement un circuit (2) d'acheminement de signaux de sortie de module à un ou plusieurs circuit (3) d'achemincement de signaux d'entrée de module et qu'ensuite on met en oeuvre le mode de contrôle externe du procédé de contrôle Boundary-Scan.
